# EUROPEAN PATENT APPLICATION

(11) **EP 0 620 591 A1**
(43) Date of publication of application: **19.10.1994**
(21) Application number: 94200722.0
(22) Date of filing: 21.03.1994
(51) Int. Cl.: H01L 23/31, H01L 23/29

(54) **Silicone over-mould of a flip-chip device**

(30) Priority: 12.04.1993 US 46189
(71) Applicant: DELCO ELECTRONICS CORPORATION, Kokomo Indiana 46902 (US)
(72) Inventor: Hall, Gregory Lynn, Azle, Texas 76020 (US); Lake, Donald Eugene, Rochester, Indiana 46975 (US)
(74) Representative: Denton, Michael John

(57) **Abstract**

Disclosed is an electronic flip-chip device (12) encapsulated in an elastomeric silicone rubber material (16). Also disclosed is a method of encapsulating a flip-chip electronic device (12) including placing the flip-chip electronic device (12) in a mould (28,30) and injecting a self-hardening silicone composition (16) into the mould (28,30) at a temperature so that solder bumps (14) of the flip-chip device (12) do not collapse and the flip-chip device (12) maintains its position above the substrate (10) on which it is mounted. The moulding process also prevents the solder bumps (14) from flowing and short-circuiting the hybrid circuit. The electronic device may be held in a position in the mould by support pins (22) connected to the periphery of the substrate (10) of the device. The support pins (22) extend from, and are supported by, a rigid support strip (20).

## Description

The present invention generally relates to electronic devices including encapsulated flip-chip electronic devices as specified in the preamble of claim 1.

Electronic devices have been encapsulated by a variety of materials. However, encapsulation of electronic devices having flip-chips thereon has been particularly problematic. In the manufacture of "flip-chip" devices, an integrated circuit is made in a silicon chip. Solder bumps are formed on one face of the chip at locations on the integrated circuit where electrical connection is desired. The chip is "flipped" over and mounted by the solder bumps to a hybrid circuit so that the integrated circuit side of the chip is face down. The use of flip-chips has a variety of advantages, one of which is to elevate the chip above the surface of the substrate to which it is mounted. In the elevated position, the chip operates at cooler temperatures due to improved heat dissipation. Flip-chips also eliminate potential parasitic effects associated with wire bonding to other types of chips.

Maintaining the integrity of the solder bump and the level of the flip-chip above the substrate is extremely important. Encapsulation processes which involve moulding a material at high temperatures around a flip-chip is undesirable. The high temperature of such moulding processes causes the solder bumps to flow, often resulting in the short-circuiting of the hybrid circuit, therefore causing the chip to fail, or the flip-chip becoming elevated in a lopsided orientation.

Thus, it would be desirable to develop an encapsulated flip-chip electronic device, and method of making the same, which does not cause the solder bumps to flow, and which maintains the integrity and position of the flip-chip on the device.

A semi-conductor device according to the present invention is characterised by the features specified in the preamble of claim 1.

Generally, the invention includes an electronic flip-chip device encapsulated in silicone material. The invention also includes a method of encapsulating a flip-chip electronic device which includes placing the flip-chip electronic device in a mould and injecting a self-hardening silicone composition at a temperature that will prevent collapse of the solder bumps on the flip-chip and will maintain the position of the flip-chip above the substrate. The moulding process also prevents the solder bumps from flowing and short-circuiting the hybrid circuit to which the flip-chip is mounted. The substrate on which the hybrid circuit is formed may be held in a suspended position in an encapsulation mould by support pins connected to the periphery of the substrate. The support pins extend from and are supported by a rigid support strip which runs parallel to a side of the substrate and are directly supported by the mould.

The invention and how it may be performed are hereinafter particularly described with reference to the accompanying drawings, in which:
Figure 1 is a sectional view of a flip-chip positioned on a ceramic substrate according to the present invention;
Figure 2 is an illustration of an electronic device having a flip-chip thereon and having support pins and support strips attached to the substrate according to the present invention;
Figure 3 is an exploded view of a mould and an electronic device including support pins and support strips according to the present invention;
Figure 4 is an illustration of a semi-conductor device having support pins and support strips attached thereto and a silicone encapsulation according to the present invention; and
Figure 5 is an exploded illustration of an encapsulated electronic device secured to a substrate by support pins according to the present invention.

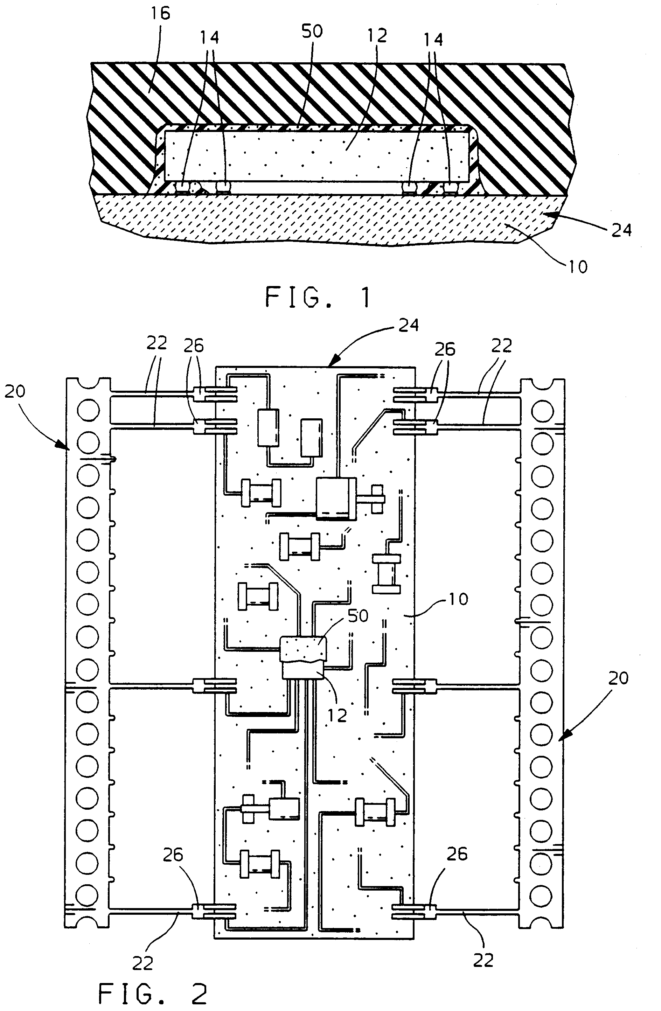

Figure 1 illustrates an electronic device including a ceramic substrate 10 having a hybrid circuit formed thereon including a flip-chip 12. The flip-chip 12 is secured to the substrate 10 and electronically connected to the hybrid circuit by solder bumps 14. The advantages of flip-chips in hybrid circuit devices are known to those skilled in the art. It is also known that it is important to maintain the position of the flip-chip relative to the substrate. The solder bumps should not collapse or flow so as to cause a short in the hybrid circuit.

According to the present invention, an electronic device including a flip-chip 12 is encapsulated with an elastomeric silicone rubber 16. A suitable encapsulation composition includes silicone compounds and inhibited catalysts which cause the composition to cure when heated to a temperature ranging from about 110°C to about 150°C. The elastomeric silicone rubber-encapsulated device can be easily handled during further processing without damage to the flip-chip. The elastomeric silicone encapsulation is flexible enough to allow the flip-chip to thermally expand during operation thereof without damage thereto. The encapsulated device may be mounted on a circuit board and undergo washing steps with solvents like Freon (R.T.M.) and water without damage to the encapsulation material or to the flip-chip. Further, the silicone encapsulation will not swell during water washes. Heretofore flip-chip devices had to be passivated after washing steps.

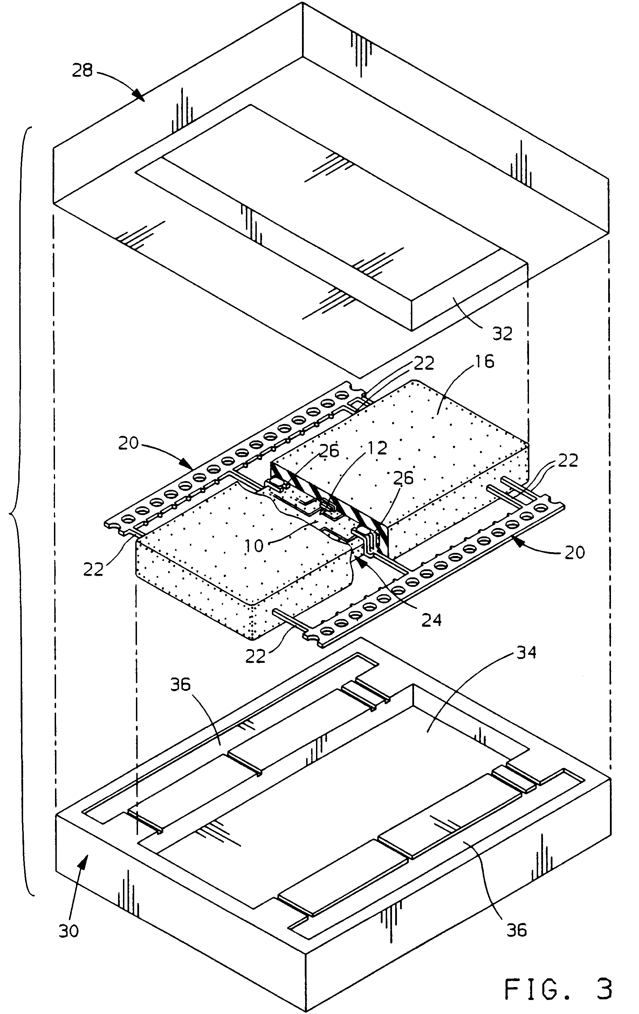

According to the present invention, a support strip 20 having at least two support pins 22 extending therefrom is connected to at least two sides of an electronic device 24 as illustrated in Figure 2. The support pins are preferably mechanically connected to the electronic device by a clasp 26. Alternatively, the support pins can be bonded or welded to the sides of the electronic device. The electronic device 24 having a flip-chip 12 thereon and support strips 20 is placed in a mould (see Figure 3) having top and bottom shells 28, 30 so that the electronic device 24 is suspended in a cavity of the mould. Each shell defines a cavity 32, 34 of the mould which corresponds to a portion of the shape of the encapsulated product. The mould also has a cavity 36 for receiving the support strips 20 and support pins 22 so that the support strips 20 are directly supported by the mould.

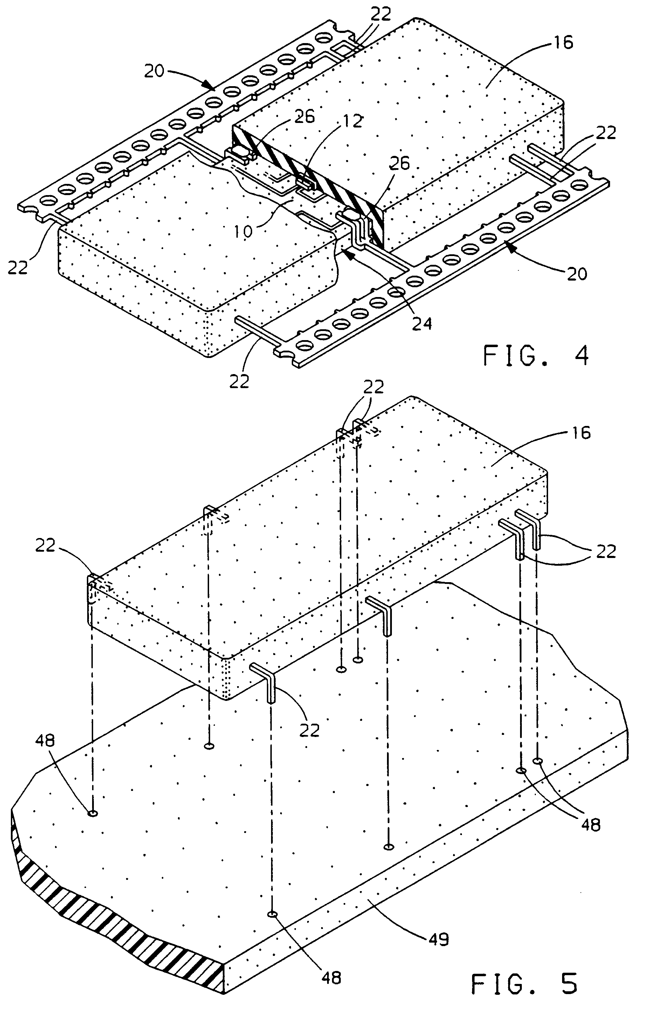

The elastomeric silicone composition is injected into the mould cavity at a pressure of about 620.53 kPa (90 psi) with a 3.175 mm (1/8") orifice. The mould is heated so that the silicone composition cures to a solid protective material completely encasing the electronic device 24. Thereafter, the support pins 22 may be broken off at the edge of each support strip 20 to form a finished product. Alternatively, the support pins 22 may be bent downwardly and inserted in mounting holes 48 in a substrate such as a circuit board 49 (see Figure 5). At least one of the support pins 22 provides electrical connection between the encapsulated device 24 and a circuit formed on the circuit board 49. Alternatively, the support pins 22 may be pulled away from the electronic device 24 leaving a small hole in the cured silicone material 16. Likewise, the support pins 22 may be removed from the electronic device 24 as the silicone material solidifies sufficiently to support the electronic device 24 in a predetermined position in the mould. In such an embodiment, the silicone material 16 may flow over the void left by the removed support pins 22 and cure to form a single protective coating free of holes.

In one embodiment, a hybrid circuit is formed on a ceramic substrate. The ceramic substrate has a length of about 44.45 mm (1.75"), a width of about 15.875 mm (0.625"), and a thickness of about 0.889 mm (0.035"). Perforated metal strips having support pins 22 extending substantially perpendicularly therefrom are placed along two sides of the ceramic substrates. The support pins have metal clasps which are pressure-fitted to the ceramic substrate. The hybrid circuit includes a flip-chip having solder bumps bonded to electrical leads. This sub-assembly is placed in an injection-mould cavity. The mould cavity for the ceramic substrate has a length of about 47.498 mm (1.87"), a width of about 19.05 mm (0.75"), and a height of about 6.35 mm (0.25"). A two-component silicone composition is injected into the mould cavity at a pressure of about 620.53 kPa to 2068.428 kPa (90 psi to 300 psi) with a 3.175 mm (1/8") orifice, and cured at a temperature of about 150°C. After which, the silicone composition is cured to a solid protective coating encapsulating the electronic device. The support pins are snipped off at the edge of the support strip as described above. Putting a protective housing around the silicone encapsulation material to further protect the electronic device is not necessary. For the above device, the amount of silicone composition injected at room temperature is about 4 grams.

A suitable silicone composition is available from the Dow Corning Corporation, USA under the trade name SILASTIC^{R} Q3-9595 A/B, which is a thixotropic, two-part silicone elastomer for liquid injection-moulding. The system may include a triorganosiloxy end-blocked polydimethylsiloxane fluid containing vinyl groups in the triorganosiloxy units and an amorphous silica having vinyl-containing organosiloxane groups bonded to its surface to cure to elastomers as described in U.S. Patent No. 4,162,243, the disclosure of which is hereby incorporated by reference. Another suitable elastomeric silicone rubber composition is described in U.S. Patent No. 3,445,420, the disclosure of which is hereby also incorporated by reference. Curing of the silicone composition is accomplished by heating the composition to raise the temperature of the composition to about 110°C which will instantly cure the composition to a tough elastomeric material. The rate of cure decreases with reduced temperature and the silicone composition requires at least 24 hours to cure at room temperature (25°C). The silicone composition is supplied in kits of A and B components to be combined in a 1:1 ratio before use. In a preferred embodiment, SILASTIC^{R} is injected at about 1896.059 kPa (275 psi) and at about 120°C. The time for filling the mould is approximately 45 seconds, and the cure time is 75 seconds.

A small amount, about 1-2 eye-droplets, of an elastic dielectric silicone gel 50 may be used to coat and further protect the flip-chip 12 (see Figure 1) . The silicone gel material 50 is flexible and allows the flip-chip 12 to thermally expand during operation with less stress on the flip-chip 12 than if the device is encapsulated only by the elastomeric silicone rubber 16. A suitable elastic dielectric silicone gel material is available from Dow Corning Company, USA under product number Q3-6635 and under the trade name SYLGARD^{R}. However, the elastomeric silicone rubber material (SILASTIC^{R}) used to encapsulate the entire device is sufficiently flexible to prevent damage to the chip during operation without the use of the silicone gel (SYLGARD^{R}).

The disclosures in United States patent application no. 046,189, from which this application claims priority, and in the abstract accompanying this application are incorporated herein by reference.

## Claims

1. A semi-conductor device (24) comprising a ceramic substrate (10) having a hybrid circuit formed thereon, said hybrid circuit including a flip-chip (12) and solder bumps (14) bonded to electrical leads of the hybrid circuit, characterised in that said ceramic substrate (10) and hybrid circuit are encapsulated by a cured, hardened silicone composition (16).

2. A semi-conductor device (24) according to claim 1, in which said cured, hardened silicone composition (16) encapsulating said ceramic substrate (10) and hybrid circuit comprises a material formed from a silicone composition comprising a triorganosiloxy end-blocked polydimethylsiloxane in which the triorganosiloxy units contain vinyl groups.

3. A semi-conductor device according to claim 1, in which the hybrid circuit formed thereon forms an electronic device (24) having soldered components; and said ceramic substrate (10) and said electronic device (24) are encapsulated by an elastomeric silicone composition (16).

4. A semi-conductor device (24) according to any one of claims 1 to 3, in which there is not a protective housing surrounding said silicone-encapsulated ceramic substrate (10) and hybrid circuit.

5. A method of forming an encapsulated semi-conductor device (24) according to claim 1, which method comprises providing said ceramic substrate (10) having a hybrid circuit formed thereon including said flip-chip (12) and solder bumps (14) bonded to electrical leads of the hybrid circuit; placing said ceramic substrate (10) and hybrid circuit formed thereon in a mould cavity (32,34) at a pre-selected position therein; and injecting into said cavity (32,34) a silicone composition (16) at a pressure ranging from about 620.53 kPa to 2068.428 kPa (90 to 300 psi) and at a temperature ranging from about 110°C to about 150°C; so that said silicone composition (16) cures to a hard protective material encapsulating said ceramic substrate (10) and said hybrid circuit formed thereon without causing the solder bumps (14) to flow and short-circuit the device (24).

6. A method according to claim 5, in which said ceramic substrate (10) further includes a pair of support members (20), each of which is connected to a respective side of the ceramic substrate (10), each of said support members (20) including at least two support pins (22) extending substantially perpendicularly from said strips (20) and being connected to said substrate (10).

7. A method according to claim 6, in which said support member (20) comprises a rigid metal.

8. A method according to claim 7, which method further comprises the step of snipping-off said support pins (22) near an outer edge of said silicone composition (16) encapsulating said ceramic substrate (10) and said hybrid circuit.
